# EUROPEAN PATENT APPLICATION

(11) **EP 2 590 237 A2**
(43) Date of publication of application: **08.05.2013**
(21) Application number: 12181851.2
(22) Date of filing: 27.08.2012
(51) Int. Cl.: H01L 33/50, H01L 33/54

(54) **Light-emitting module and illumination device**

(30) Priority: 01.11.2011 JP 2011240534
(71) Applicant: Toshiba Lighting & Technology Corporation, Yokosuka-shi Kanagawa 237-8510 (JP)
(72) Inventor: Shibusawa, Soichi, Kanagawa 237-8510 (JP); Hayashida, Yumiko, Kanagawa 237-8510 (JP); Nakagawa, Yuiko, Kanagawa 237-8510 (JP); Tamai, Hiroki, Kanagawa 237-8510 (JP)
(74) Representative: Willquist, Sofia Ellinor

(57) **Abstract**

According to one embodiment, a light-emitting module (20a, 20b, 20c, 20d, 20e, 20f) includes a substrate (21), a light-emitting element (36a, 36b, 36c) and a sealing member (45). The light-emitting element (36a, 36b, 36c) is mounted on the substrate (21). The sealing member (45) is formed of a material consisting principally of a translucent resin (45a) containing phosphor particles (46). The sealing member (45) includes a main portion (50) covering the light-emitting element (36a, 36b, 36c) and an outer peripheral portion (51) coming into contact with the substrate (21). A content percentage of the phosphor particles (46) with respect to the resin (45a) is smaller in the outer peripheral portion (51) of the sealing member (45) than that in the main portion (50).

## Description

### FIELD

Embodiments described herein relate generally to a light-emitting module including light-emitting elements mounted on a substrate and covered with a resin sealing member containing phosphor particles and an illumination device using the light-emitting module as a light source.

### BACKGROUND

A COB (chip on board) type light-emitting module is widely used as a light source of an illumination device. The light-emitting module of this type includes a plurality of light-emitting diodes mounted on a substrate. The light-emitting diodes are arranged at a distance with respect to each other and are respectively sealed by sealing members having translucency.

The sealing member is formed of a material composed principally of resin containing phosphor particles. The sealing member is formed by dropping the material of the sealing member onto the substrate by using, for example, a dispenser and hardening the dropped material by heating. Accordingly, the sealing member is maintained in a shape swelled into a dome shape from the substrate. The sealing members protect the light-emitting diodes on the substrate from oxygen or moisture in the air.

The phosphor particles contained in the sealing member are excited by light emitted by the light-emitting diodes and emit light having a color in complementary relationship with respect to the light emitted by the light-emitting diodes. Consequently, the light emitted by the light-emitting diodes and the light emitted by the phosphor particles are mixed with each other in the interior of the sealing member, and becomes white light. The white light is radiated out of the light-emitting module and is provided for lighting.

The phosphor particles are dispersed substantially uniformly in the resin which is a principal component of the sealing member. However, the phosphor particles themselves are lack of adhesiveness. Therefore, when the phosphor particles are interposed at a boundary between the sealing member and the substrate, the adhesiveness of the sealing member with respect to the substrate is impaired by the phosphor particles. Consequently, the adhesive strength of the sealing member is not sufficient, which may be one of causes of separation of the sealing member.

### BRIEF DESCRIPTION OF THE DRAWINGS

FIG. 1 is an exemplary appearance perspective view of an illumination device according to an embodiment;
FIG. 2 is an exemplary plan view of the illumination device;
FIG. 3 is an exemplary cross-sectional view taken along the line F3-F3 in FIG. 2;
FIG. 4 is an exemplary plan view of a light-emitting module according to the embodiment;
FIG. 5 is an exemplary plan view of F5 in FIG. 4 in an enlarged scale;
FIG. 6 is an exemplary cross-sectional view taken along the line F6-F6 in FIG. 5;
FIG. 7 is an exemplary cross-sectional view showing a positional relationship between a mounting pad on which first to third light-emitting diodes are mounted and a sealing member; and
FIG. 8 is an exemplary cross-sectional view schematically showing a configuration of the sealing member.

### DETAILED DESCRIPTION

In general, according to one embodiment, a light-emitting module includes a substrate, a light-emitting element and a sealing member. The light-emitting element is mounted on the substrate. The sealing member is formed of a material composed principally of a translucent resin containing phosphor particles. The sealing member includes a main portion configured to cover the light-emitting element and an outer peripheral portion coming into contact with the substrate in the periphery of the main portion. The content percentage of the phosphor particles with respect to the resin is lower in the outer peripheral portion of the sealing member than in the main portion.

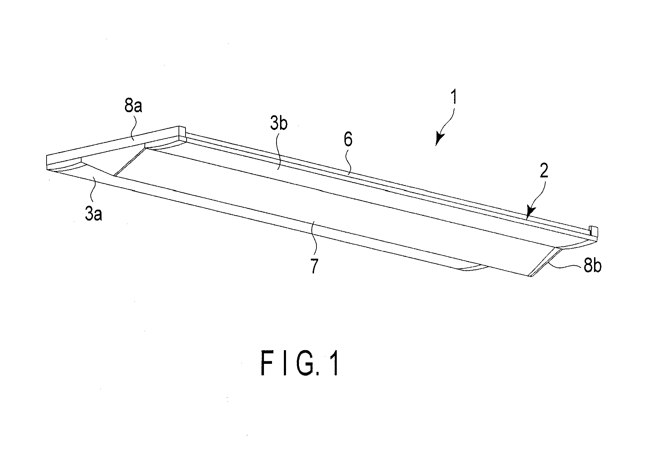

Referring now to FIG. 1 to FIG. 8, an embodiment will be described.

FIG. 1 to FIG. 3 illustrate a base light 1 for general lighting. The base light 1 is an example of an illumination device used, for example, indoors, surface mounted to a ceiling surface R of a building.

The base light 1 is provided with an apparatus body 2, a pair of shades 3a and 3b, a light source 4, and a lighting circuit 5. The apparatus body 2 has a chassis 6, a center cover 7, a first side cover 8a, and a second side cover 8b.

The chassis 6 is formed of, for example, a galvanized steel plate and has an elongated shape extending along the ceiling surface R. The chassis 6 includes a fixing portion 10, and a pair of light source supporting portions 11a and 11b.

The fixing portion 10 has a substantially flat plate shape and is fixed to an element which constitutes a ceiling of a building, for example, with a plurality of screws. The light source supporting portions 11a and 11b are arranged in parallel to each other having the fixing portion 10 therebetween. The light source supporting portions 11a and 11b each have a flat supporting surface 12. The supporting surface 12 protrudes downward with respect to the fixing portion 10, and extends straight in the longitudinal direction of the chassis 6.

The center cover 7 is mounted to the fixing portion 10 of the chassis 6. The center cover 7 projects into a V-shape downward of the chassis 6 from between the light source supporting portions 11a and 11b.

The first side cover 8a covers one end along the longitudinal direction of the chassis 6 and one end along the longitudinal direction of the center cover 7 continuously. The second side cover 8b covers the other end along the longitudinal direction of the chassis 6 and the other end along the longitudinal direction of the center cover 7 continuously.

The shades 3a and 3b are formed of translucent resin material such as acryl resin or polycarbonate resin. The shades 3a and 3b extend straight in the longitudinal direction of the chassis 6.

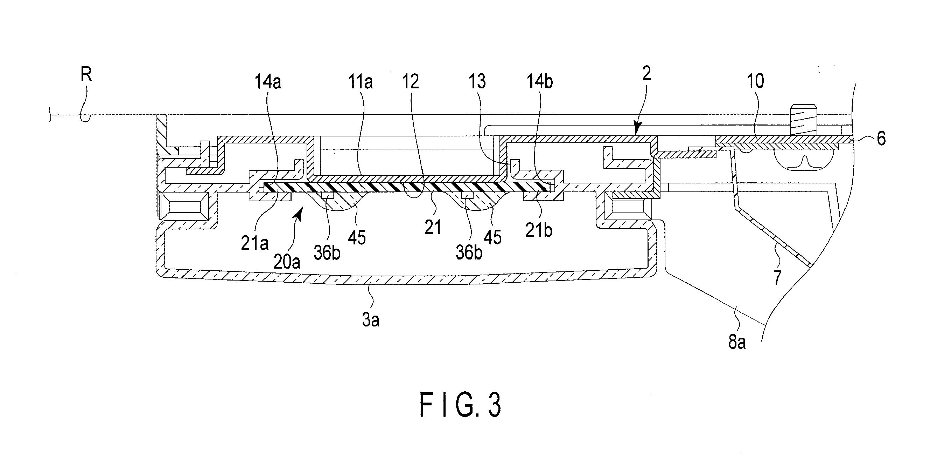

As illustrated in FIG. 3 with one shade 3a as a representative, the shades 3a and 3b each include an opening 13. The openings 13 have a slit shape extending in the longitudinal direction of the chassis 6, and are opened toward the light source supporting portions 11a and 11b of the chassis 6. A pair of holding grooves 14a and 14b are formed at edges of the opening 13. The holding grooves 14a and 14b extend along the entire length of the shades 3a and 3b. Opening ends of the holding grooves 14a and 14b face each other at a distance from each other in the width direction of the chassis 6.

In addition, the shades 3a and 3b are mounted on the chassis 6 via a plurality of brackets. When the shades 3a and 3b are mounted on the chassis 6, the light source supporting portions 11a and 11b of the chassis 6 are covered by the shades 3a and 3b from below.

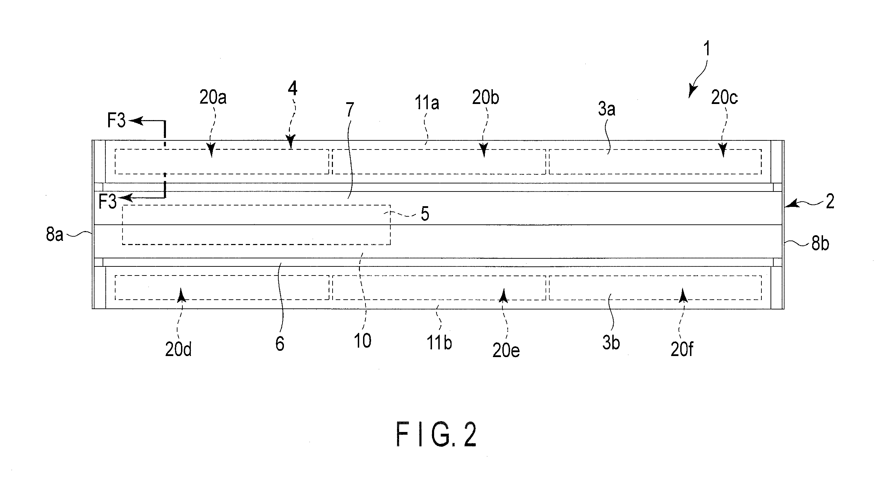

As illustrated in FIG. 2, the light source 4 includes a first to sixth light-emitting modules 20a, 20b, 20c, 20d, 20e and 20f. The first to sixth light-emitting modules 20a, 20b, 20c, 20d, 20e and 20f have an elongated shape extending in the longitudinal direction of the light source supporting portions 11a and 11b.

According to the embodiment, the first to third light-emitting modules 20a, 20b and 20c are held by the holding grooves 14a and 14b of the shade 3a, and are arranged in a line so as to extend along the longitudinal direction of the light source supporting portion 11a. In the same manner, the fourth to sixth light-emitting modules 20d, 20e and 20f are held by the holding grooves 14a and 14b of the shade 3b, and are arranged in a line so as to extend along the longitudinal direction of the light source supporting portion 11b.

Therefore, the first to sixth light-emitting modules 20a, 20b, 20c, 20d, 20e and 20f are integrated with the shades 3a and 3b and are covered with the shades 3a and 3b. In addition, the first to sixth light-emitting modules 20a, 20b, 20c, 20d, 20e and 20f are electrically connected in series.

The lighting circuit 5 is an element configured to control lighting of the first to sixth light-emitting modules 20a, 20b, 20c, 20d, 20e and 20f, and converts an AC current output from an AC power source into a DC current and supplies the same to the first to sixth light-emitting modules 20a, 20b, 20c, 20d, 20e and 20f. The lighting circuit 5 is supported by the fixing portion 10 of the chassis 6 and is covered with the center cover 7.

The first to sixth light-emitting modules 20a, 20b, 20c, 20d, 20e and 20f have a structure common to each other. Therefore, in the embodiment, the first light-emitting module 20a is described as a representative example.

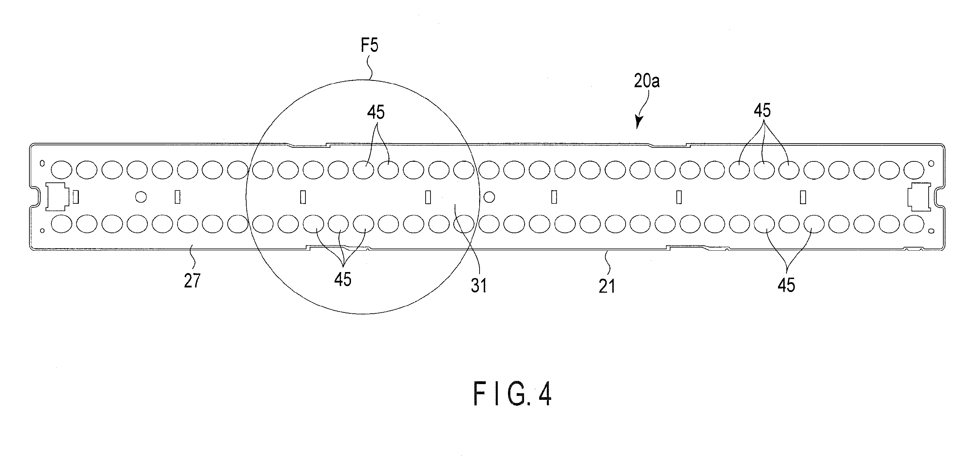

As illustrated in FIG. 4 to FIG. 6, the first light-emitting module 20a includes a substrate 21. The substrate 21 has a three-layer structure having a base 22, a metallic layer 23, and a resist layer 24. The base 22 is formed of a synthetic resin such as epoxy resin or a glass composite substrate, and has an elongated shape extending in the longitudinal direction of the chassis 6.

The metallic layer 23 is formed of, for example, copper foil. The metallic layer 23 is laminated on a back surface 22a of the base 22. The resist layer 24 is formed of an insulating material such as synthetic resin, for example. The resist layer 24 is laminated continuously on the metallic layer 23 and an outer peripheral portion of the back surface 22a of the base 22. The metallic layer 23 and the resist layer 24 reinforce the substrate 21 in cooperation with each other in order to prevent warping of the substrate 21.

As illustrated in FIG. 3, the substrate 21 includes a pair of side edges 21a and 21b extending in the longitudinal direction. The side edges 21a and 21b of the substrate 21 are inserted into the holding grooves 14a and 14b of the shade 3a from one end along the longitudinal direction of the shade 3a. Consequently, the substrate 21 is held by the shade 3a, and the resist layer 24 of the substrate 21 comes into contact with the supporting surface 12 of the light source supporting portion 11a.

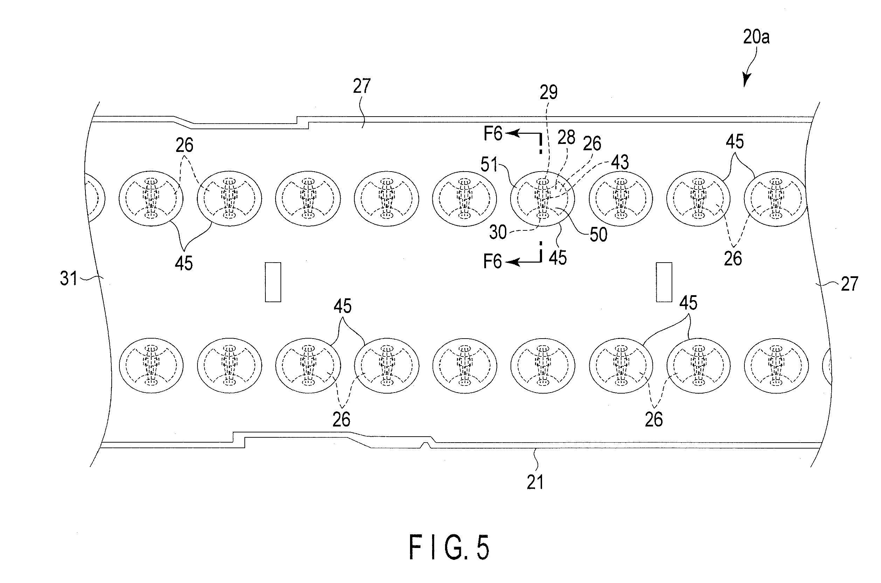

As illustrated in FIG. 5 to FIG. 7, a plurality of conductive patterns 26 and an insulating layer 27 are laminated on a front surface 22b of the base 22. The conductive patterns 26 are arranged in two rows at a distance in the width direction of the substrate 21, and are apart from each other in the longitudinal direction of the substrate 21 in each row.

The conductive patterns 26 each include a mounting pad 28, a first wiring pad 29, and a second wiring pad 30. The mounting pad 28 employs a three-layer structure including, for example, a combination of first to third metallic layers C, N, S laminated one on top of another.

Specifically, the first metallic layer C is formed by applying etching on copper foil laminated on the front surface 22b of the base 22. The second metallic layer N is laminated on the first metallic layer C. The second metallic layer N is formed by applying nickel plating on the first metallic layer C. The third metallic layer S is laminated on the second metallic layer N. The third metallic layer S is formed by applying silver plating on the second metallic layer N. The third metallic layer S forms a surface layer of the mounting pad 28. Therefore, a surface of the mounting pad 28 corresponds to a silver light-reflecting surface 31. The total beam reflectance of the light-reflecting surface 31 is preferably, for example, at least 90%.

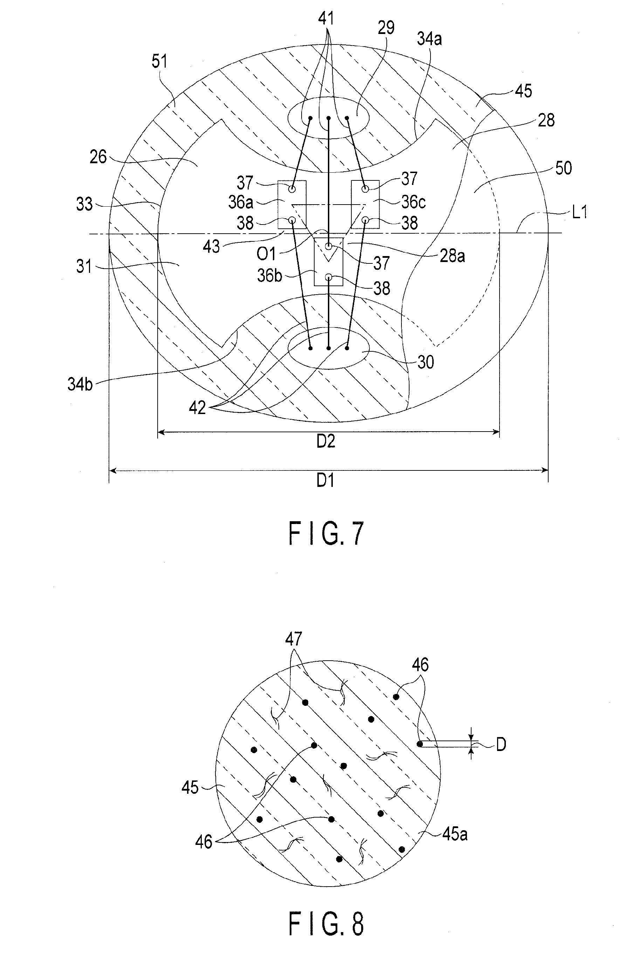

As illustrated in FIG. 7, the mounting pad 28 in this embodiment has a substantially oval shape and has a longitudinal axis L1 extending in the direction in which the conductive patterns 26 are arranged. The mounting pad 28 includes an outer peripheral edge 33 curved into an arc shape and a pair of depressed portions 34a and 34b. The depressed portions 34a and 34b each have a shape formed by notching the outer peripheral edge 33 of the mounting pad 28 in an arcuate shape toward a center O1 of the mounting pad 28 where the longitudinal axis L1 passes. The depressed portions 34a and 34b are arranged in the direction orthogonal to the longitudinal axis L1 of the mounting pad 28.

In other words, the depressed portions 34a and 34b face each other having the center O1 of the mounting pad 28 therebetween. Therefore, the mounting pad 28 has a form narrowed at a central portion 28 including the center 01, and the substantial surface area of the mounting pad 28 is held down.

The first wiring pad 29 and the second wiring pad 30 have an oval shape significantly smaller than the mounting pad 28, and have the same size with each other. The first wiring pad 29 and the second wiring pad 30 have a three-layer structure having the first to third metallic layers C, N, S in the same manner as the mounting pad 28, and surface layers thereof are formed of silver.

The first and second wiring pads 29 and 30 are formed on the front surface 22b of the base 22 corresponding to the depressed portions 34a and 34b of the mounting pad 28. In other words, the first wiring pad 29 and the second wiring pad 30 are distributed in the direction orthogonal to the longitudinal axis L1 of the mounting pad 28 with respect to the center O1 of the mounting pad 28, and are arranged symmetrically with each other with respect to the longitudinal axis L1.

In addition, the first wiring pad 29 and the second wiring pad 30 are apart from the depressed portions 34a and 34b of the mounting pad 28, and are kept in a state of being electrically insulated from the mounting pad 28. In other words, the depressed portions 34a and 34b of the mounting pad 28 are notched so as to avoid the first wiring pad 29 and the second wiring pad 30.

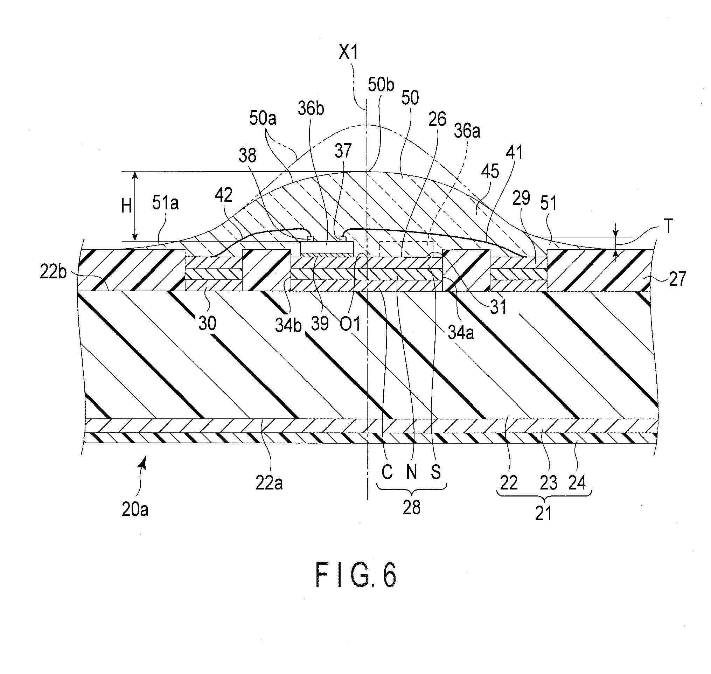

As illustrated in FIG. 6, the insulating layer 27 is laminated on the front surface 22b of the base 22. The insulating layer 27 covers an area of the front surface 22b of the base 22 other than the mounting pad 28, the first wiring pad 29, and the second wiring pad 30. Therefore, the surface layer of the mounting pad 28, the surface layer of the first wiring pad 29, and the surface layer of the second wiring pad 30 are not covered with the insulating layer 27 and are exposed out from the substrate 21.

Part of the insulating layer 27 is filled between the mounting pad 28 and the first wiring pad 29, and between the mounting pad 28 and the second wiring pad 30. In addition, the insulating layer 27 protrudes in the thickness direction of the substrate 21 with respect to the surface layer of the mounting pad 28, the surface layer of the first wiring pad 29, and the surface layer of the second wiring pad 30.

According to the embodiment, the insulating layer 27 is formed of, for example, a white resin material having an electrical insulating property. The insulating layer 27 also has a function as a light reflecting layer.

As illustrated in FIG. 7, first to third light-emitting diodes 36a, 36b, and 36c are mounted on the light-reflecting surface 31 of the mounting pad 28. The first to third light-emitting diodes 36a, 36b, and 36c are an example of the light-emitting element. The first to third light-emitting diodes 36a, 36b, and 36c are formed of common bear chips configured to emit blue light, for example. The respective bear chips have a rectangular shape in plan view and, for example, the length of the long side is 600 to 650 µm and the length of the short side is 200 to 250 µm.

Furthermore, the respective bear chips each have a first electrode 37 as an anode and a second electrode 38 as a cathode. The first and second electrodes 37 and 38 are arranged at a distance in the longitudinal direction of the bear chips.

The first to third light-emitting diodes 36a, 36b, and 36c are respectively bonded to the light-reflecting surface 31 using a die-bonding material 39 having translucency. According to the embodiment, the first to third light-emitting diodes 36a, 36b, and 36c are arranged at a distance in the direction of the longitudinal axis L1 of the mounting pad 28 at the central portion 28a of the mounting pad 28 and are arranged in a zigzag pattern with respect to the longitudinal axis L1.

Specifically, the first light-emitting diode 36a and the third light-emitting diode 36c are shifted toward the first wiring pad 29 with respect to the longitudinal axis L1. The second light-emitting diode 36b is shifted toward the second wiring pad 30 with respect to the longitudinal axis L1.

Therefore, as illustrated by a double dashed chain line in FIG. 7, the first to third light-emitting diodes 36a, 36b, and 36c are arranged at a position corresponding just to three corners of a triangle so as to surround the center 01 of the mounting pad 28 at the central portion 28a of the mounting pad 28.

The first electrodes 37 of the first to third light-emitting diodes 36a, 36b, and 36c are each electrically connected to the first wiring pad 29 via a first bonding wire 41 individually. The second electrodes 38 of the first to third light-emitting diodes 36a, 36b, and 36c are each electrically connected to the second wiring pad 30 via a second bonding wire 42 individually.

Consequently, the first to third light-emitting diodes 36a, 36b, and 36c bonded respectively to the mounting pad 28 constitute a diode group 43 connected in parallel to each other. The light-emitting diodes 36a, 36b, and 36c of the diode group 43 on the mounting pad 28 are connected in series along the direction of arrangement of the conductive patterns 26 and constitute two rows of diode rows corresponding to the conductive patterns 26 on the substrate 21.

Furthermore, according to the embodiment, the diode group 43 is grounded via the chassis 6 of the apparatus body 2.

As illustrated in FIG. 4 to FIG. 7, a plurality of sealing members 45 are arranged on the substrate 21. The sealing members 45 are arranged in two rows at a distance in the width direction of the substrate 21 so as to correspond to the conductive patterns 26, and are apart from each other in the longitudinal direction of the substrate 21 in each row.

The sealing members 45 are elements for sealing the diode groups 43 bonded to the mounting pads 28 and the first and second bonding wires 41 and 42 corresponding to the diode groups 43 on the substrate 21. As schematically illustrated in FIG. 8, the sealing members 45 consist primarily of a resin 45a, and include a predetermined amount of phosphor particles 46 and a predetermined amount of filler 47 mixed in the resin 45a.

As the resin 45a, for example, a resin-based silicone resin or a hybrid-based silicone resin having translucency are preferably used. The resin-based silicon resin and the hybrid-based silicone resin have a three-dimensionally bridged structure, and hence are harder than translucent silicone rubber.

In addition, the resin-based silicone resin provides lower performance to allow transmission of gas such as oxygen or moisture vapor than silicone oil or silicone rubber. In the case of the embodiment, oxygen transmittance of the resin 45a is 1200 cm³ (m²·day·atm) or below and moisture transmittance is 35g/m² or below.

By selecting the resin 45a of this type, degrading of the mounting pad 28 caused by transmittance of the gas in the atmosphere through the sealing members 45 is prevented. Therefore, the light-reflecting property of the light-reflecting surface 31 is desirably maintained.

The phosphor particles 46 have a diameter D of 1 µm or above, and are dispersed in the resin 45a substantially uniformly. As the phosphor particles 46, yellow phosphor particles which are excited by the blue light emitted by the bear chips and emit yellow light are used.

The phosphor particles 46 to be mixed with the resin 45a are not limited to the yellow phosphor particles. For example, in order to improve color rendering properties of the light emitted from the bear chips, red phosphor particles configured to be excited by the blue light and emit red light, or green phosphor particles emitting green light may be added to the resin 45a.

The sealing member 45 is swelled from the insulating layer 27 of the substrate 21 so as to enclose integrally the mounting pad 28, the first and second wiring pads 29 and 30 corresponding to the mounting pad 28, the diode group 43 on the mounting pad 28, and the first bonding wire 41 extending across the diode group 43 and the first wiring pad 29 and the second bonding wire 42 extending across the diode group 43 and the second wring pad 30.

The sealing member 45 is formed by dropping the resin 45a in a liquid state before being hardened toward the mounting pad 28. When dropping the material of the sealing member 45, a dispenser is preferably used. The material of the sealing member 45 dropped toward the mounting pad 28 is hardened into a dome shape by being heated at a temperature of, for example, 150°C for 60 minutes.

According to the sealing member 45 in the embodiment, the resin 45a as the principal component thereof has physicality which maintains a predetermined shape even in a state of not being hardened immediately after the resin is dropped toward the mounting pad 28. The physicality of the resin 45a means thixotropy, viscosity, and hardness.

In other words, as illustrated in FIG. 6, the sealing member 45 is configured to maintain the flat dome shape so as to continuously cover the mounting pad 28, the first and second wiring pads 29 and 30, the diode group 43 and the first and second bonding wires 41 and 42 even in a state of not hardened immediately after the resin is dropped on the mounting pad 28.

As illustrated in FIG. 5 and FIG. 7 in plan view, the dome shaped sealing members 45 have a substantially oval shape having commonly the longitudinal axis L1 of the mounting pad 28 and are arranged in the longitudinal direction of the substrate 21 at a distance. The sealing member 45 includes a main portion 50 swelling from the mounting pad 28 and an outer peripheral portion 51 surrounding the main portion 50.

The main portion 50 is provided so as to be substantially coaxial to a reference line X1 passing through the center O1 of the mounting pad 28 and extending in the thickness direction of the substrate 21. The main portion 50 is bonded to surfaces of the mounting pad 28, the first and second wiring pads 29 and 30, and the insulating layer 27 continuously in a state of covering the diode group 43 and the first and second bonding wires 41 and 42.

The main portion 50 includes a spherical outer surface 50a. The outer surface 50a is curved so as to form an arc having a large curvature. A top portion 50b of the outer surface 50a is positioned on the reference line X1. A height H from the top portion 50b to the bear chips of the first to third light-emitting diodes 36a, 36b, and 36c is preferably 1.0 mm or above in order to inhibit the color difference depending on the angles.

The outer peripheral portion 51 of the sealing member 45 surrounds the main portion 50 so as to define the outer shape of the oval sealing member 45. The outer peripheral portion 51 is positioned around the diode group 43 and, for example, is bonded across the outer peripheral portion of the mounting pad 28 to the surface of the insulating layer 27.

The outer peripheral portion 51 includes an outer surface 51a. The outer surface 51a of the outer peripheral portion 51 is smoothly continued to the outer surface 50a of the main portion 50 without forming a level difference. Simultaneously, the outer surface 51a of the outer peripheral portion 51 is curved so as to form an arc facing opposite the arc formed by the outer surface 50a of the main portion 50.

The outer peripheral portion 51 of the sealing member 45 is reduced in a thickness T abruptly as going away from the diode group 43, and is flared so as to extend along the surface of the insulating layer 27. An outer diameter D1 of the sealing member 45 along the direction of the longitudinal axis L1 of the mounting pad 28 is larger than an outer diameter D2 of the mounting pad 28 extending along the direction of the longitudinal axis L1 of the mounting pad 28. Therefore, the mounting pad 28 and the first and second wiring pads 29 and 30 do not protrude from the sealing member 45.

Furthermore, according to the embodiment, the thickness T of the outer peripheral portion 51 of the sealing member 45, for example, at a boundary portion continuing to the main portion 50 is smaller than the diameter D of the phosphor particles 46. Therefore, in the course of hardening of the resin 45a having thixotropy, major part of the phosphor particles 46 contained in the resin 45a stops in the main portion 50 of the sealing member 45.

In other words, even when the phosphor particles 46 dispersed in the main portion 50 make an attempt to move from the main portion 50 to the outer peripheral portion 51, the thixotropy and the viscosity of the resin 45a limit the free movement of the phosphor particles 46. Consequently, the phosphor particles 46 in the resin 45a are banked up at the boundary portion between the main portion 50 and the outer peripheral portion 51. Therefore, in the outer peripheral portion 51 of the sealing member 45, the content percentage of the phosphor particles 46 dispersed in the resin 45a is held down to a level as low as possible in comparison with the main portion 50.

Therefore, according to the embodiment, the phosphor particles 46 do not exist in the outer peripheral portion 51 of the sealing member 45, and major area of the outer peripheral portion 51 is formed of the resin 45a containing the filler 47.

When a power switch of the base light 1 is turned ON, a DC voltage is applied from the lighting circuit 5 to the conductive patterns 26 of the first to sixth light-emitting modules 20a, 20b, 20c, 20d, 20e and 20f. Accordingly, the diode groups 43 mounted on the plurality of the mounting pads 28 emit light altogether.

Blue light emitted from the bear chips of the diode group 43 enters the sealing member 45. Part of the blue light entering the sealing member 45 is absorbed by the phosphor particles 46. The remaining part of the blue light passes through the sealing member 45 without being absorbed by the phosphor particles 46.

The phosphor particles 46 which absorbed the blue light are excited and emit yellow light which is a complementary color with respect to blue light. The yellow light passes through the sealing member 45. Therefore, the yellow light and the blue light are mixed to each other in the interior of the sealing member 45 and generate white light. The white light passes through the sealing member 45 and the shades 3a and 3b and is radiated out of the base light 1, and is provided to light the room from the ceiling surface R.

According to the embodiment, the sealing member 45 which seals the mounting pad 28, the first and second wiring pads 29 and 30, the diode group 43, the first and second bonding wires 41 and 42 on the substrate 21 includes the outer peripheral portion 51 flared so as to extend along the surface of the insulating layer 27. In the outer peripheral portion 51 of the sealing member 45, the phosphor particles 46 lacking adhesiveness are not dispersed in the resin 45a, and the resin 45a which defines the shape of the outer peripheral portion 51 is bonded to the surface of the insulating layer 27.

Therefore, in the outer peripheral portion 51 of the sealing member 45, the phosphor particles 46 are not interposed at the boundary portion between the sealing member 45 and the surface of the insulating layer 27, and hence the adhesiveness of the sealing member 45 with respect to the substrate 21 is not impaired by the phosphor particles 46.

In such a case, if the insulating layer 27 is formed of a material of the same system as the resin 45a which consists principal component of the sealing member 45 such as silicone resin, for example, the insulating layer 27 and the resin 45a are blended well to each other. Accordingly, the adhesiveness between the insulating layer 27 and the resin 45a is further enhanced. Therefore the adhesive strength of the sealing member 45 is sufficiently secured, and separation or rattling of the sealing member 45 may be inhibited.

In this embodiment, the outer peripheral portion 51 of the sealing member 45 where the phosphor particles 46 do not exist extends across the surface of the insulating layer 27 and the outer peripheral portion of the mounting pad 28. Therefore, the adhesiveness at the boundary portion between the sealing member 45 and the mounting pad 28 is preferably secured.

In addition, the phosphor particles 46 are eliminated spontaneously from the resin 45a which defines the outer peripheral portion 51 of the sealing member 45 in the course until the uncured material of the sealing member 45 is dropped on the substrate 21 and cured. Therefore, a special process or a post process does not have to be performed on the outer peripheral portion 51 of the sealing member 45, and hence the workability when forming the sealing member 45 is not impaired.

According to the embodiment, the mounting pad 28 has the depressed portions 34a and 34b notched into an arcuate shape toward the center 01 of the mounting pad 28, and hence has a shape narrowed at the central portion 28a of the mounting pad 28. Therefore, the substantial surface area of the mounting pad 28 which serves as the light-reflecting surface 31 is held down. In addition, the first and second wiring pads 29 and 30 to which the first and second bonding wires 41 and 42 are connected have a significantly smaller shape than the mounting pad 28, and the surface areas of the first and second wiring pads 29 and 30 are held down.

In this configuration, the surface areas of the mounting pad 28 and the first and second wiring pads 29 and 30 may be held down to minimum required surface areas, so that an excessive electrical charge is prevented from accumulating between grounding portions of the first to sixth light-emitting modules 20a, 20b, 20c, 20d, 20e and 20f and the conductive patterns 26 including the mounting pad 28 and the first and second wiring pads 29 and 30.

Consequently, when the power switch of the base light 1 is turned OFF and the first to sixth light-emitting modules 20a, 20b, 20c, 20d, 20e and 20f are extinguished, minute current caused by floating capacitance can hardly flow to the diode groups 43 of the first to sixth light-emitting modules 20a, 20b, 20c, 20d, 20e and 20f. Therefore, malfunctioning of the base light 1 in which the diode groups 43 emit light weakly can be prevented.

In the embodiment described above, the outer peripheral portion of the sealing member is configured so that the phosphor particles do not exist. However, the configuration of the sealing member is not limited thereto. For example, the phosphor particles of an amount which does not affect the adhesiveness of the sealing member may be contained in the resin which defines the outer peripheral portion of the sealing member. In other words, the content percentage of the phosphor particles in the outer peripheral potion of the sealing member is not limited to zero.

The shape of the outer surface 50a of the main portion 50 of the sealing member 45 is not limited to that in the embodiment. For example, as shown by a double-dashed chain line in FIG. 6, the outer surface 50a of the main portion 50 may be formed to project in the direction away from the substrate 21 in comparison with the embodiment, and may be curved so as to form a spherical surface having a curvature smaller than that of the embodiment.

In addition, the planer shape of the sealing member is not limited to the oval shape, and may be, for example, a true circle.

The first to the third light-emitting diodes are not to be limited to being arranged so as to surround the center of the mounting pad, and may be arranged for example, in a row at a distance from each other so as to extend along the longitudinal axis of the mounting pad, or a single light-emitting diode may be mounted at the center of the mounting pad. Therefore, items relating to the number and the arrangement of the light-emitting diodes are not specifically limited.

In addition, the light-emitting module is not limited to the light source for the base light to be surface mounted to the ceiling. For example, the light-emitting module may be used as a light source of a straight tube lamp to be used instead of, a straight-tube fluorescent lamp.

Also, the illumination device is not limited to the base light configured to be surface mounted to the ceiling. For example, the illumination devices of other forms such as street lights or guide lights may also be applicable in the same manner.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting module **characterized by** comprising:
a substrate (21);
a light-emitting element (36a, 36b, 36c) mounted on the substrate (21); and
a sealing member (45) consisting primarily of a translucent resin (45a) containing phosphor particles (46), the sealing member (45) including a main portion (50) covering the light-emitting element (36a, 36b, 36c) and an outer peripheral portion (51) coming into contact with the substrate (21) in the periphery of the main portion (50), and having a content percentage of the phosphor particles (46) with respect to the resin (45a) smaller in the outer peripheral portion (51) than that in the main portion (50).

2. The light-emitting module of claim 1, **characterized in that** the sealing member (45) has a shape swelled from the substrate (21).

3. The light-emitting module of claim 1 or 2, **characterized in that** the outer peripheral portion (51) of the sealing member (45) is positioned in the periphery of the light-emitting element (36a, 36b, 36c), and has a shape flared along the substrate (21) so that a thickness is decreased as going away from the light-emitting element (36a, 36b, 36c).

4. The light-emitting module any one of claims 1 to 3, **characterized in that** the thickness of the outer peripheral portion (51) of the sealing member (45) is smaller than a diameter of the phosphor particles (46).

5. The light-emitting module any one of claims 1 to 4, **characterized in that** the content percentage of the phosphor particles (46) with respect to the resin (45a) is zero in the outer peripheral portion (51) of the sealing member (45).

6. The light-emitting module any one of claims 1 to 4, **characterized in that** the outer peripheral portion (51) of the sealing member (45) has an area formed of the resin (45a) containing a filler (47).

7. The light-emitting module any one of claims 1 to 6, **characterized in that** the main portion (50) of the sealing member (45) has a spherical outer surface (50a), and the outer peripheral portion (51) of the sealing member (45) surrounds the main portion (50) and has an outer surface (51a) continuing smoothly to the outer surface (50a) of the main portion (50).

8. The light-emitting module of claim 7, **characterized in that** the outer surface (51a) of the outer peripheral portion (51) is curved so as to form an arc facing opposite an arc formed by the outer surface (50a) of the main portion (50).

9. The light-emitting module any one of claims 1 to 8, **characterized by** further comprising a conductive pattern (26) formed on the substrate (21); and
an insulating layer (27) laminated on the substrate (21) so as to avoid the conductive pattern (26), wherein
the outer peripheral portion (51) of the sealing member (45) is bonded to the insulating layer (27).

10. The light-emitting module of claim 9, **characterized in that** the insulating layer (27) is formed of a material of the same system as the resin (45a) which is a principal component of the sealing member (45).

11. The light-emitting module of claim 9 or 10, **characterized in that** the conductive pattern (26) includes a mounting portion (28) on which the light-emitting element (36a, 36b, 36c) is mounted and a plurality of wiring portions (29, 30) to which the light-emitting element (36a, 36b, 36c) are electrically connected, and
the mounting portion (28) and the wiring portions (29, 30) are covered with the sealing member (45).

12. The light-emitting module of claim 11, **characterized in that** the mounting portion (28) includes a light reflecting surface (31) configured to reflect light emitted by the light-emitting element (36a, 36b, 36c).

13. The light-emitting module any one of claims 1 to 12, **characterized in that** the resin (45a) is lower in oxygen transmittance and moisture transmittance than silicone oil and silicone rubber.

14. The light-emitting module any one of claims 11 to 13, **characterized in that** the outer peripheral portion (51) of the sealing member (45) is bonded so as to extend across both the insulating layer (27) and the mounting portion (28).

15. An illumination device **characterized by** comprising:
a main body (2); and
a light-emitting module (20a, 20b, 20c, 20d, 20e, 20f) as defined in any one of claims 1 to 14 supported by the main body (2).
